# EUROPEAN PATENT APPLICATION

(11) **EP 4 838 557 A1**
(43) Date of publication of application: **11.11.2026**
(21) Application number: 25174830.7
(22) Date of filing: 07.05.2025
(51) Int. Cl.: H01L 21/48, H01L 21/02, H01L 23/498, H01L 23/538, B33Y 10/00, B33Y 30/00, B33Y 50/00, B33Y 80/00

(54) **CHIP PACKAGING VIA ADDITIVE MANUFACTURING WITH EMBEDDED REINFORCEMENT STRUCTURES**

(71) Applicant: Nederlandse Organisatie voor toegepast- natuurwetenschappelijk onderzoek TNO, 2595 DA 's-Gravenhage (NL)
(72) Inventor: WALSH, Darragh Robert, 2595 DA 's-Gravenhage (NL); AKKERMAN, Hylke Broer, 2595 DA 's-Gravenhage (NL)
(74) Representative: V.O.

(57) **Abstract**

Methods are provided for manufacturing a chip package using an additive manufacturing process. A plurality of layers of a dielectric material is formed in a layer-by-layer fashion, wherein one or more layers are structured to define void regions. These void regions include a chip cavity for embedding a chip die, interconnect channels for forming electrical tracks filled with a conductive material, and reinforcement channels filled with a reinforcement material. The reinforcement structure is configured to structurally reinforce the chip package, in particular during curing, and is functionally independent from any electrical function of the package. Also provided are methods of designing such a chip package, comprising simulation-based evaluation and adjustment of the reinforcement structure to control residual stress and deformation. Chip packages resulting from these methods are also provided.

## Description

### TECHNICAL FIELD AND BACKGROUND

The present disclosure relates to chip packages and methods of designing and manufacturing chip packages, in particular by using additive manufacturing techniques.

Additive manufacturing (AM) may provide a flexible and digitally controlled approach for producing integrated circuit packages. Such methods may allow the construction of multilayer dielectric structures by depositing and curing dielectric materials in a layer-wise fashion. Within these structures, electronic components such as chip dies may be embedded, and features such as electrical interconnects, cavities, and vias may be defined with high spatial precision.

While additive manufacturing enables novel form factors and integration possibilities, it may also introduce challenges in terms of mechanical reliability. Chip packages produced by AM processes may experience residual stress accumulation during fabrication, particularly when the package comprises materials with differing thermal or mechanical properties. For example, shrinkage of photopolymer-based dielectric materials during thermal curing may generate internal stresses within the package body. These stresses may be further amplified by mismatches in the coefficients of thermal expansion between embedded components and surrounding materials.

In some cases, such residual stresses may result in package warpage, delamination at internal interfaces, or even mechanical failure of embedded semiconductor dies. This may be particularly problematic for chip dies with high aspect ratios, for thin components, or for package designs that require precise mechanical tolerances.

Conventional techniques for mitigating such effects-developed primarily for use in standard molded packaging technologies-may not be directly applicable to additive manufacturing workflows. In particular, existing strategies often rely on bulk material additions, external supports, or rigid component placement schemes that may not be compatible with digitally patterned, maskless fabrication processes.

Accordingly, there remains a need for further developments in the design and manufacturing of chip packages using additive manufacturing, particularly in view of mechanical stress management and structural integrity under thermal or processing loads.

### SUMMARY

According to some aspects of the present disclosure, a method is provided for manufacturing a chip package using an additive manufacturing process. By forming a plurality of layers of a dielectric material in a layer-by-layer fashion, a multilayer packaging structure is built up that allows for precise definition of internal features through digitally controlled patterning. By structuring one or more of the layers to include void regions, functional and mechanical features can be embedded directly into the dielectric body of the package. By defining a chip cavity within the structured layers, a chip die can be encapsulated within the package, thereby enabling protection and integration of the chip into the overall structure. By including interconnect channels that are filled with a conductive material, electrical tracks are formed within the dielectric material which establish electrical connection with the contacts of the chip die, thereby enabling electrical functionality of the package. By further including reinforcement channels within the same or other structured layers, which are filled with a reinforcement material that is materially distinct from the dielectric material, a reinforcement structure is formed within the dielectric body. By embedding such a reinforcement structure, deformation of the chip package during curing of the dielectric material can be alleviated, thereby improving mechanical integrity and dimensional stability. By ensuring that the reinforcement structure is functionally independent from any electrical function of the package, it does not interfere with the operation of the embedded electronic components, allowing structural and electrical design to be independently optimized.

According to preferred embodiments, the set of reinforcement channels may comprise elongated grooves extending in-plane along the surface of a respective layer. The inventors find that, by defining the reinforcement structure as a set of reinforcement lines, a directional stiffening effect may be introduced, which may allow stress distribution within the dielectric body to be selectively modulated along defined orientations. For example, this may enable more precise control over deformation patterns that arise during thermal cycling or material curing.

By aligning the reinforcement lines substantially parallel to the in-plane length direction of the chip die, where the die exhibits a larger lateral dimension compared to its width, the reinforcement structure may counteract deformation that tends to occur preferentially along the longer axis of the chip. By arranging these reinforcement lines in a layer parallel to the chip die and overlapping with the in-plane projection of the die, the reinforcement structure exerts a constraining effect directly in the regions most prone to stress accumulation. By extending the reinforcement lines beyond the edges of the chip die, anchoring into the surrounding dielectric material is achieved, thereby enhancing the distribution of mechanical load and improving structural resilience.

In some embodiments, the reinforcement channels are defined as a grid pattern comprising reinforcement lines in both the length and width directions of the chip die. By employing such a grid pattern, a more uniform and bidirectional constraint is provided, which may be advantageous in managing warpage in chip packages with square or near-square geometries or in applications requiring isotropic reinforcement.

Alternatively or additionally, the reinforcement lines may be oriented diagonally relative to the in-plane axes of the chip die. By positioning diagonal reinforcement lines to intersect the chip corners, localized reinforcement is introduced at locations that typically exhibit the highest residual stresses. By extending these diagonal grooves along the chip's diagonals and beyond its corners into the dielectric material, crack initiation and propagation at these critical regions can be effectively mitigated.

By forming at least part of the reinforcement structure from an electrically conductive material, while maintaining electrical isolation from the conductive tracks and the chip die contacts, the reinforcement material can benefit from the desirable mechanical properties of conductive pastes or inks without interfering with the electrical design. This enables efficient material usage, particularly where the same paste is used for both reinforcement and interconnection.

In some embodiments, the same conductive material is used to fill both the interconnect channels and the reinforcement channels within a single layer. By enabling simultaneous deposition of both functional and non-functional conductive features using a shared process step-such as blade coating-manufacturing efficiency is improved, reducing process complexity and cost.

In a further preferred embodiment, all of the reinforcement material throughout the package may be the same as the conductive material used for the electrical tracks. By using a single material for both purposes and ensuring spatial separation where necessary, material logistics and deposition processes are simplified, without compromising electrical performance.

By applying the conductive and/or reinforcement material across the surface of a respective layer and urging it into the structured cavities using a spreading element-such as a doctor blade or squeegee-bulk or area-wide deposition is achieved. This process allows all void regions in a layer to be filled in a single application step, enhancing scalability and process uniformity.

By pick-and-placing the chip die into the cavity during the manufacturing process, prior to forming additional dielectric layers above it, full embedding of the chip die is enabled. This encapsulation enhances environmental protection and structural integrity. By forming layers both above and below the die, the chip is surrounded by dielectric material, contributing to mechanical robustness and planar integration.

By employing a digital, maskless additive manufacturing process to define each of the void regions, the design of chip packages can be adapted quickly and without the need for physical masks or tooling. This digital flexibility supports low- to medium-volume production with application-specific customization.

By selecting a reinforcement material with a lower coefficient of thermal expansion and/or a higher elastic modulus than the dielectric material, mechanical mismatch may be intentionally leveraged to counteract cure-induced deformation. This material contrast may introduce internal constraints within the package that may reduce residual stress accumulation and improve dimensional stability.

According other or further aspects of the disclosure, a method is provided for designing a chip package in which the internal mechanical behavior is optimized through simulation-driven reinforcement placement. By providing an initial digital design comprising a multilayer dielectric structure with one or more embedded chip dies and associated interconnect structures, the mechanical integrity of the package can be assessed prior to fabrication. By calculating the stress and/or deformation distribution within the chip package using numerical modeling-e.g., taking into account curing shrinkage and thermal effects-critical regions prone to warpage or stress concentration can be identified.

By comparing the simulated results with predefined mechanical tolerance thresholds, it becomes possible to determine whether reinforcement is required. If excessive stress or deformation is predicted, the design may be modified by embedding a reinforcement structure as described herein, e.g. comprising a pattern of elongate reinforcement lines. For example, by selecting the orientation of this pattern based on the principal directions of deformation or stress accumulation, and by positioning the reinforcement lines to overlap with or extend beyond the projection of the chip die, local mechanical weaknesses can be addressed with high spatial precision. By ensuring that the reinforcement structure is functionally independent from the electrical circuitry of the package, electrical reliability is maintained while mechanical performance is enhanced.

The simulation and/or design adjustment may be applied iteratively until the resulting package meets the required mechanical integrity criteria. In this way a design process may be established that is suited to the additive manufacturing processes as described herein. By generating a finalized digital design file containing all relevant structural and functional geometries-including the reinforcement layout-an integrated method may be provided from virtual design to physical realization using digital additive manufacturing processes.

According to other or further aspects of the present disclosure, a chip package is provided which may be manufactured and/or designed according to the methods described herein. The chip package comprises a multilayer dielectric structure formed from a plurality of additively manufactured layers, wherein at least some of the layers are structured to define internal void regions. These void regions include a chip cavity encapsulating a chip die, interconnect channels filled with conductive material to form embedded electrical tracks, and reinforcement channels filled with a reinforcement material distinct from the dielectric material.

By embedding such a reinforcement structure within the package body, and by ensuring that it is functionally independent from any electrical function of the package, structural integrity and reliability of the chip package may be improved without compromising the electrical design. The arrangement and material selection of the reinforcement structure may correspond to any of the configurations described above, including grid-based, longitudinal, or diagonal reinforcement lines, optionally formed from the same conductive paste used for electrical interconnects. The chip package thus embodies a structural architecture in which mechanical performance is digitally co-optimized alongside electrical functionality, within the context of additive manufacturing.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A-1H schematically illustrate a method of manufacturing a chip package using an additive manufacturing process, showing sequential deposition of dielectric layers, chip die placement, and filling of interconnect and reinforcement features.
FIGs 2A-2C illustrate different cross-sectional arrangements of interconnect and reinforcement materials across multiple layers of a chip package, including examples of material combinations and spatial configurations.
FIGs 3A-3C schematically show the working principle of shrinkage-induced reinforcement using cured ink-filled grooves, demonstrating the mechanical interaction between reinforcement material and surrounding dielectric during and after curing.
FIGs 4A and 4B present simulated stress distributions in a chip package without reinforcement, highlighting the effect of cure shrinkage on residual stress and deformation.
FIGs 5A-5C compare different reinforcement groove patterns through simulation and experimental observation, showing their respective influence on warpage behavior in 3D printed polymer specimens.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

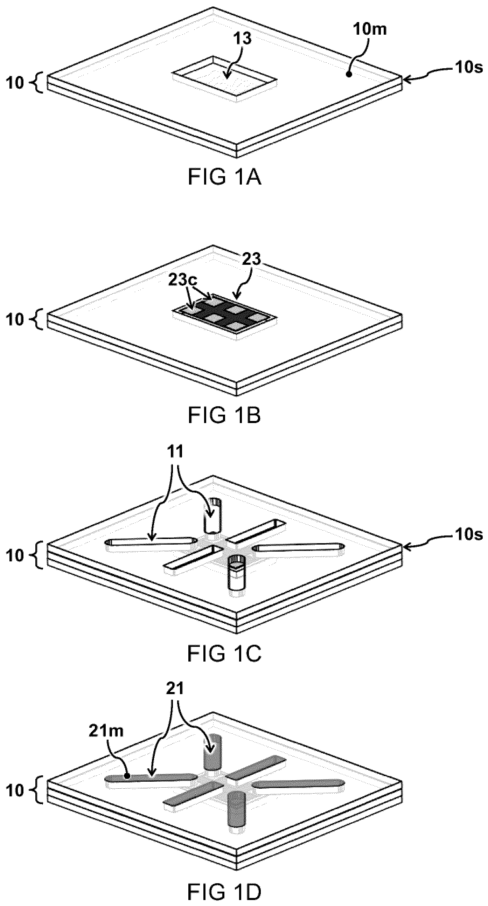

FIGs 1A-1H illustrate a method of manufacturing a chip package 100. As described herein, the chip package 100 is manufactured using an additive manufacturing, AM, process. In the AM process, a plurality of layers 10 of a dielectric material 10m may be formed to build up, layer-by-layer, a packaging structure. One or more of the plurality of layers 10 are structured layers 10s. In particular, the AM process may be used to define respective void regions 11,12,13 within the structured layers 10s.

As illustrated in FIG 1A, the respective void regions may include a chip cavity 13 which is intended to at least partially encapsulate a chip die 23 within the chip package 100. As illustrated in FIG 1B, the chip die 23 may have a set of electrical contacts 23c. In principle, the chip package 100 may also contain more than one chip die / chip cavity, or one or more other cavities for embedding one or more other electronic components within the chip package 100.

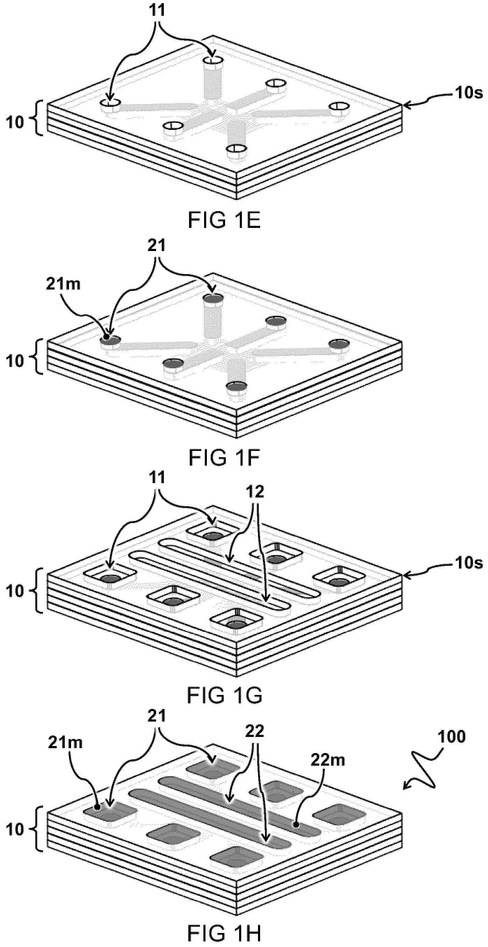

As illustrated in any of FIGs 1C, 1E, and 1G, the respective void regions may further include a set of interconnect channels 11. As illustrated in any of FIGs 1D, 1F, and 1H, the set of interconnect channels may be filled by a conductive material 21m to form a set of electrical tracks 21 which may be embedded in the dielectric material 10m. Typically, the set of electrical tracks 21 may be (directly or indirectly) electrically connected with the set of electrical contacts 23c of the chip die 23.

In some embodiments, e.g. as illustrated in FIG 1D the set of electrical tracks 21 may include a set of electrical lines extending longitudinally in plane along a respective layer of the plurality of layers 10. In other or further embodiments, e.g. as illustrated in FIG 1F, the set of electrical tracks 21 include a set of electrical vias 21v through a respective layer of the plurality of layers 10 for electrically interconnecting respective parts of the respective electrical tracks on either side of the respective layer. In other or further embodiments, e.g. as illustrated in FIG 1H, the set of electrical tracks 21 include a set of contact pads 21p electrically connected to the set of electrical contacts 23c, e.g. via the set of electrical lines 211 and/or set of electrical vias 21v.

Typically, at least some of the electrical tracks 21 are electrically connected with respective electrical contacts 23c of the chip die 23 for establishing external electrical contact with the chip die 23 encapsulated within the chip package 100. For example, one or more of the set of electrical tracks 21 may be used for an electrical interconnection between a respective one or more of the set of electrical contacts 23c and a respective one or more (external) contact points, e.g. contact pads. When used, the contact points may be exposed on an outside of the chip package 100. During manufacturing, the contact points may be initially embedded within the dielectric material 10m and exposed later, e.g. through grinding. Alternatively, or in addition to interconnecting with external contact points, one or more of the electrical tracks 21 may be used to electrically interconnect respective electrical contacts 23c of the chip die with any other electrical components that may also be embedded within the chip package 100.

As illustrated in FIG 1G, the respective void regions may include a set of reinforcement channels 12. As illustrated in FIG 1H, the set of reinforcement channels 12 may be filled by a reinforcement material 22m to form a reinforcement structure 22 embedded in the dielectric material 10m. As described herein, the reinforcement structure 22 is arranged for structurally reinforcing the dielectric material 10m of the chip package 100. In particular, the reinforcement structure 22 is configured to alleviate deformation of the chip package 100 and/or stresses within the chip package 100 during curing. For example, the reinforcement structure 22 may prevent or alleviate deformation caused by heating and/or evaporation. It will be understood that the reinforcement structure 22 is functionally independent from any electrical function of the chip package 100. For example, the reinforcement structure 22 may be electrically non-conductive and/or electrically disconnected from any electrical circuitry in the chip package 100. Preferably, the reinforcement material 22m is materially distinct from the dielectric material 10m forming the plurality of layers 10. The reinforcement material 22m may also be materially distinct from the conductive material 21m, or the same material may be used.

In principle, the dielectric material 10m may be any suitable material that can be processed using additive manufacturing techniques. Typically, the dielectric material is an insulating material so that it can provide electrical isolation between conductive elements of the package. In a preferred embodiment, the dielectric material comprises a photopolymer that can be cured by exposure to electromagnetic radiation, such as ultraviolet light. In other or further embodiments, the dielectric material may include thermoplastic polymers, thermosetting polymers, hybrid materials, or composite materials that can be deposited in a layer-by-layer fashion.

In principle, the conductive material 21m may be any suitable material that can be provided into the void regions forming the interconnect channels, and processed to form electrically conductive pathways within the chip package. Preferably, the conductive material is provided in the form of a conductive ink or a conductive paste. A conductive ink is generally understood as a flowable composition containing conductive particles suspended in a carrier medium with a viscosity suitable for deposition techniques such as printing or jetting. A conductive paste may refer to a thicker, more viscous form of conductive material that may maintain at least some of its shape after deposition and may be suitable for techniques such as stencil printing, screen printing, or blade coating. Both conductive inks and conductive pastes typically comprise metallic particles such as silver, copper, gold, aluminum, nickel, or alloys thereof suspended in a carrier medium that may include solvents, binders, and additives that facilitate deposition, adhesion, and curing. The viscosity of suitable conductive material may typically range from about 1 to about 10,000 Pa.s, depending on the specific deposition method employed. After deposition into the interconnect channels, the conductive material typically undergoes a curing process, which may include thermal treatment, to form solid conductive pathways. During this curing process, the carrier medium may evaporate or transform, allowing the metallic particles to form a conductive network. It will be understood that the cured conductive material should possess electrical conductivity sufficient for reliable signal transmission and/or power delivery to the chip die.

In principle, the reinforcement material 22m may be any suitable material that can be provided into the void regions forming the reinforcement channels, and processed to form mechanical reinforcement structures within the chip package. Preferably, the reinforcement material is provided in the form of a flowable composition, such as an ink or paste, that can be deposited into the reinforcement channels using techniques such as dispensing, blade coating, screen printing, or stencil printing. The reinforcement material may comprise particles (such as metallic particles, ceramic particles, polymer composites with high modulus fillers, or combinations thereof), suspended in a carrier medium (which may include solvents, binders, and additives facilitating deposition, adhesion, and curing). After deposition, the reinforcement material typically undergoes a curing or solidification process to form solid reinforcement structures.

In some embodiments, the reinforcement material 22m has a different, preferably lower, coefficient of thermal expansion than the dielectric material 10m. This may enable control of residual stresses in in particular during a heating and/or curing of the chip package 100. For example, the reinforcement material 22m may have a coefficient of thermal expansion (CTE) that is at least 50% lower than that of the dielectric material 10m. This significant difference in thermal expansion properties may allow the reinforcement structure to constrain the expansion and/or contraction of the surrounding dielectric material during temperature changes, thereby maintaining a controlled stress distribution within the package.

In other or further embodiments, the reinforcement material 22m has a different, preferably higher, elastic modulus than the dielectric material 10m. This may enable control of deformation patterns within the chip package 100 by providing directional stiffness. For example, the reinforcement material 22m may have an elastic modulus that is at least two or three times higher than that of the dielectric material 10m. The higher stiffness of the reinforcement material creates preferential deformation paths in the package during thermal cycling, directing strain away from critical regions such as the corners of the chip die 23 where stress concentrations typically occur.

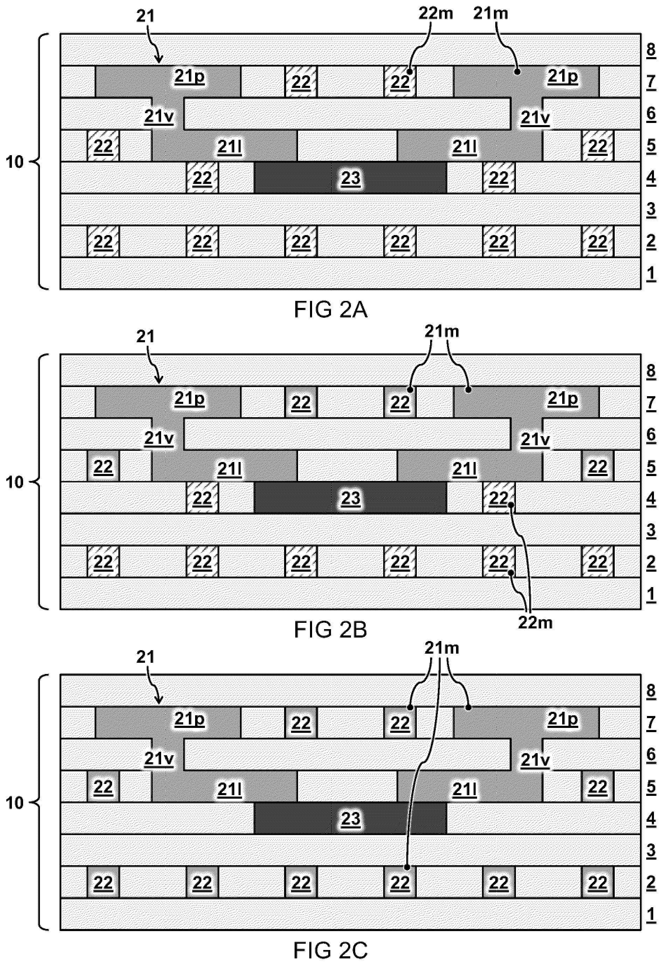

FIGs 2A-2C illustrate a respective cross-section view for different arrangements of materials 21m,22m in the layers 10 forming a chip package. In the figures, the individual layers are numbered 1 through 8. For example, the chip die 23 is arranged in layer 4, a set of electrical lines 211 is arranged in layer 5, a set of electrical vias 21v is arranged in layer 6, and a set of set of contact pads 21p is arranged in layer 7. Of course also other arrangements having more or fewer layers may be envisaged. While the present embodiment illustrates the chip die 23 exactly fitting the thickness of one layer, in general, the chip die 23 may extend through multiple layers or even have a thickness that is less than the layer thickness.

In some embodiments, e.g. as illustrated in FIG 2A, at least some of the reinforcement material 22m is materially distinct from the conductive material 21m. In the figures the different material 22m is indicated by a hatched background pattern. In principle, some or all of the reinforcement material 22m may be formed of non-conductive material. Alternatively, or in addition, some or all of the reinforcement material 22m may be formed of a conductive material, which may be a different material than the conductive material 21m forming the set of electrical tracks 21.

For some localized or selective deposition techniques, such as dispensing, inkjet printing, screen printing, or stencil printing, it may be possible to deposit different materials in different void regions 11,12 formed in the same layer of dielectric material 10m. However, for preferred bulk or area-wide deposition techniques, such as blade coating, doctor blading, or squeegee-based filling, it is preferable that all void regions within the same layer that are being filled by a material (e.g. excluding the chip cavity) are filled by the same material. Advantageously, the filling of the respective void regions may thus be performed by a single step or process.

In a preferred embodiment, deposition of the conductive material 21m and/or the reinforcement material 22m is performed using a bulk or area-wide deposition technique, such that all void regions within the same layer are filled with a same material in a single step. Most preferably, the deposition of the conductive material 21m and/or the reinforcement material 22m comprises distributing the material over a surface of a respective layer and urging the material into the void regions by movement of a spreading implement along the surface, thereby filling the void regions in a uniform application step. For example, the spreading implement comprises a blade, a doctor blade, a squeegee, or a wiper element. Also other or further ways may be envisaged for depositing the respective material, such as slot die coating, curtain coating, knife-over-edge coating, or roll coating, depending on the desired layer thickness, material viscosity, and surface characteristics.

Typically, the interconnect channels 11 in a respective layer are arranged so that the conductive material 21m filling the set of interconnect channels 11 in the respective layer may establish an electrical connection with part of the set of electrical tracks 21 or with at least one of the set of electrical contacts 23c of the chip die 23 provided in an adjacent layer. In some embodiments, the set of interconnect channels 11 in a respective layer comprise a structured set of open cavities. In one embodiment, e.g. as illustrated in FIGs 1C-1D and FIGs 2A-2C, the structured set of open cavities comprise one or more elongated grooves extending in-plane along the surface of the layer to define electrical lines 211. In another or further embodiment, e.g. as illustrated in FIG 1E-1F and FIGs 2A-2C, the structured set of open cavities comprise one or more through-holes extending through the thickness of the layer to define electrical vias 21v. In another or further embodiment, e.g. as illustrated in FIG 1G-1H and FIGs 2A-2C, the structured set of open cavities comprise one or more recessed areas to define contact pads 21p electrically connectable to a set of electrical contacts of an embedded chip die.

Preferably, the reinforcement channels 12, when filled with a reinforcement material 22m that is electrically conductive, are arranged such that the reinforcement material 22m does not establish electrical contact with the conductive material 21m of the set of electrical tracks 21 or with any of the electrical contacts 23c of the chip die 23. For example, this may be achieved by physical separation in the same layer and/or by positioning in different layers with at least one dielectric layer therebetween. In preferred embodiments, e.g. as illustrated in FIG 1H, the set of reinforcement channels 12 comprise a structured set of open cavities including one or more elongated grooves extending in-plane along the surface of the layer to define reinforcement lines.

In some embodiments, e.g. as illustrated in FIG 1B, the chip die 23 has an in-plane length and an in-plane width, wherein the in-plane length is larger than the in-plane width, e.g. by at least 10% (factor 1.1), at least 50% (factor 1.5), or at least a factor two. Without being bound by theory, the inventors find that residual mechanical stress during or after curing of the dielectric material may tend to induce greater warpage and deformation along the in-plane length direction. For example, this may be due to the larger span of material and/or increased out-of-plane deflection associated with thermal mismatch and cure-induced shrinkage. As a result, the chip die 23 may be more vulnerable to stress concentrations and cracking along the corners and edges extending in the in-plane length direction.

In a preferred embodiment, e.g. as illustrated in FIG 1H, at least some (or even all) of the one or more elongated grooves extends in-plane along the in-plane length direction of the chip die 23 to define respective reinforcement line that are oriented substantially parallel to said in-plane length direction. The in-plane length direction refers to the direction of the chip die 23 along which its lateral dimension is greater than its orthogonal width direction. Without being bound by theory, the inventors find that this orientation may help to counteract deformation and residual stress accumulation that tends to occur along the longer axis of the chip die due to thermal and cure-induced effects.

In a further preferred embodiment, the reinforcement lines are arranged in a layer that is parallel to the chip die 23, and are positioned such that they overlap, in projection onto the same in-plane area, with at least part of the chip die 23. Most preferably, the reinforcement lines extend at least along the full in-plane length of the chip die 23, and even more preferably extend beyond the opposing boundaries of the chip die 23. In this way, the reinforcement lines may span the entire length of the chip die and continue past its edges to anchor into the surrounding dielectric material, thereby enhancing mechanical constraint and promoting a more uniform distribution of stress around the embedded chip die.

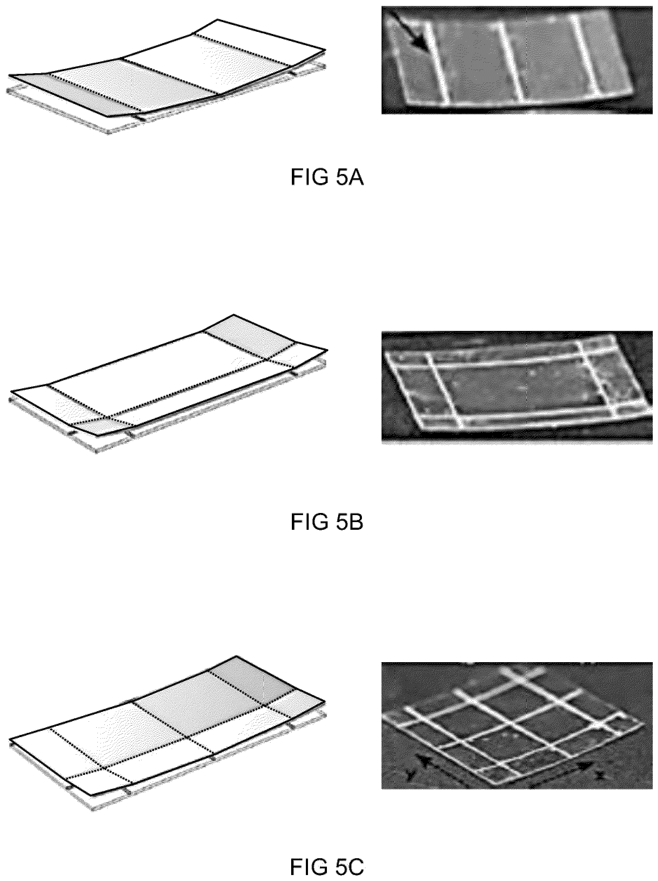

Alternatively, or in addition, the set of reinforcement channels 12 may comprise a grid pattern of intersecting elongated grooves. For example, the grid pattern comprises a first subset of reinforcement lines extending along the in-plane length direction and a second subset of reinforcement lines extending along the in-plane width direction of the chip die 23. The grid is also preferably overlapping and extending beyond the boundaries of the chip die 23, e.g. extending along the width and/or length of most, or all, of the chip package 100. The effects of various reinforcement pattern are, for example, illustrated in the simulations and corresponding experiments shown in FIGs 5A-5C.

In other or further embodiments, at least some of the one or more elongated grooves may be oriented diagonally relative to the in-plane axes of the chip die 23. In this case, the elongated grooves are preferably oriented extending in-plane across at least one corner of the chip die 23, more preferably in a direction substantially aligned with a diagonal axis of the chip die, most preferably forming a cross whose legs diagonally extends across opposite corners of the chip die 23. Also in this case, the reinforcement lines are preferably arranged to overlap, in projection, with the corner regions of the chip die 23, and most preferably extend beyond the corners of the chip die into the surrounding dielectric material. Such diagonal reinforcement lines may be particularly effective in counteracting stress concentrations that typically arise at the chip corners during curing and thermal cycling, especially in the presence of a high aspect ratio or material mismatch. By directing reinforcement material along diagonal axes, the structural stiffness of the package may be enhanced in the directions most susceptible to warpage-induced deformation or cracking. The diagonal arrangement may be implemented alone or in combination with longitudinal and/or transverse reinforcement lines, depending on the desired mechanical response of the chip package 100 and the geometry of the embedded chip die 23.

Alternatively, or in addition to grooves, the set of reinforcement channels 12 may also include one or more recessed areas or cut-outs configured to define localized reinforcement regions. Such localized regions may be provided in areas identified as critical for stress concentration or mechanical failure, such as directly above, below, or adjacent to the corners of the chip die 23. These regions may be filled with reinforcement material 22m to locally enhance stiffness or modulate deformation behavior in a targeted manner. However, the use of recessed areas or cut-outs may lead to increased material usage and may be less efficient in terms of structural effectiveness per unit of reinforcement material compared to the preferred patterns of elongated lines or grooves. Line- or grid-based reinforcement patterns generally allow for a more continuous and directional modulation of stress, while requiring less reinforcement material to achieve similar or better mechanical outcomes. Accordingly, although localized reinforcement regions may offer advantages in specific scenarios, they are typically employed in combination with, or secondary to, linear reinforcement features for optimal material efficiency and mechanical performance.

In preferred embodiments, a respective material 21m,22m is applied across the surface and urged into a respective structured set of open cavities formed in a respective layer of the dielectric material 10m by a bulk or area-wide deposition technique, such the respective structured set of open cavities is filled by the respective material 21m,22m in a single application step per layer. For example, the material 21m,22m may be deposited onto the surface of the structured dielectric layer by dispensing, coating, or spraying, and then uniformly distributed and urged into the grooves, through-holes, recessed areas, et cetera, by movement of a spreading element.

In preferred embodiments, e.g. as illustrated in FIGs 2B and 2C, any part of the reinforcement structure 22 that is formed of a conductive reinforcement material 22m, is electrically disconnected from any of the electrical contacts 23c of the chip die 23 and any conductive material 21m forming the set of electrical tracks 21. In this way, the reinforcement material 22m may be electrically conductive while remaining electrically isolated from the functional circuitry of the chip package 100. In one embodiment, the void regions 12 defining the set of reinforcement channels are spatially distinct from the void regions 11 defining the set of interconnect channels, such that there is no physical intersection or in-plane continuity between the reinforcement material 22m and the conductive material 21m within the same layer. In another or further embodiment, the reinforcement material 22m is provided in one or more layers of the plurality of layers 10 that are different from the one or more layers in which the set of electrical tracks 21 is formed, wherein the layers comprising the reinforcement material 22m are separated from the layers comprising the electrical tracks 21 by at least one intermediate dielectric layer, e.g. in case the projected layout of the reinforcement structure 22 and the set of electrical tracks 21 partially or wholly overlap in the plane.

In some embodiments, e.g. as illustrated for the layers 5 and 7 in FIGs 2A-2C, at least one layer of the plurality of layers 10 defines respective void regions which include both parts of the set of interconnect channels 11 and parts of the set of reinforcement channels 12. In preferred embodiments, e.g. as shown in FIGs 2B and 2C, in said at least one layer, the parts of the set of reinforcement channels 12 are filled by the same conductive material 21m as the parts of the set of interconnect channels 11. This may provide manufacturing advantages by enabling simultaneous deposition of both the conductive material and the reinforcement material using the same process steps and equipment. In other or further embodiments, e.g. as illustrated in FIG 2C, all reinforcement material 22m forming the reinforcement structure 22 is the same as the conductive material 21m forming the set of electrical tracks 21. In this case, it is preferably that the reinforcement structure 22 is electrically isolated from the set of electrical tracks 21. While this may place some constraint on the location of reinforcement structure 22, relative to the set of electrical tracks 21, it may also provide further advantages by not requiring a separate material to form the reinforcement structure 22.

In principle, it is not always necessary to completely avoid any parts of the reinforcement structure 22 being in electrical contact with the electrical tracks 21, as long as such contacts do not result in undesired electrical effects. Specifically, incidental or deliberate electrical contact between the reinforcement material 22m and the conductive material 21m may be permissible if it does not form short-circuit paths or otherwise compromise the intended electrical functionality of the chip package. For example, in certain configurations, the reinforcement structure 22 may be formed using a conductive material that is electrically connected to ground or maintained at a fixed potential, such that any incidental contact with adjacent conductive paths does not interfere with signal integrity.

In preferred embodiments, the chip die 23 is pick-and-placed into the chip cavity 13 during manufacturing, such that the chip die 23 is positioned and embedded within the chip package 100 prior to formation of one or more layers of the dielectric material 10 above the chip die 23. Also other or further methods for placing the chip and/or other components may be envisaged, such as automated placement using robotic dispensing systems, placement by transfer printing techniques, or insertion during intermediate stages of the additive manufacturing process in which only a partial structure has been built. In some cases, components may be premounted on temporary substrates or carriers and transferred into the cavity, followed by removal of the carrier after placement.

Most preferably, the chip die 23 is fully embedded within the chip package 100, including one or more of the plurality of layers 10 formed above the chip die 23 and one or more of the plurality of layers 10 formed below the chip die 23. In this way, the chip die 23 may be effectively protected from environmental factors such as moisture, mechanical impact, or contamination, while also allowing for integrated electrical and mechanical connection with the surrounding package structure. Complete embedding of the chip die 23 within the dielectric material 10m may further contribute to structural stability and improved thermal management within the package.

In preferred embodiments, the thickness of each layer of the plurality of layers 10 is relatively small, e.g. less than 100 µm, preferably between 10-50 µm. The thickness of the chip die 23 is preferably selected such that it corresponds approximately to an integer multiple of the layer thickness, for example equal to the thickness of one, two, or three layers. This facilitates efficient embedding of the chip die 23 within the additive manufacturing process, allowing the chip to be positioned accurately within a defined chip cavity that extends across one or more layers. For instance, when the layer thickness is approximately 50 µm, the chip die 23 may preferably have a thickness of about 50 µm, 100 µm, or 150 µm. Lateral dimensions of the chip die 23 are typically much larger than its thickness, e.g. ranging between 1 mm and 10 mm, and in some cases even larger depending on the specific application and functional requirements.

The dimensions of the electrical tracks 21 formed within the interconnect channels 11 may be on the same order as, or smaller than, the layer thickness. For example, the height and/or width of the electrical tracks 21 may be less than 50 µm, preferably less than 30 µm, and in some embodiments even below 10 µm. This allows for high-density and precisely aligned routing of electrical connections within the dielectric structure, while maintaining compatibility with the embedded chip die 23 and the resolution limits of the additive manufacturing process. Contact pads 21p, which are configured to electrically interface with the chip die 23, may have larger lateral dimensions than the electrical lines 211 or vias 21v, in order to ensure reliable alignment and connection

In preferred embodiments, the additive manufacturing process is a digital, maskless process, configured to define the respective void regions by digitally controlled patterning. Advantageously, the use of a digital, maskless additive manufacturing process eliminates the need for physical photomasks, stencils, or customized tooling for each design iteration. This may enable highly cost-effective fabrication, particularly suited for customized, low- to medium-volume production of chip packages. As will be appreciated, this digital control extends not only to the definition of electrical features and chip cavities, but also to the reinforcement structure itself. The reinforcement channels-which determine the geometry, location, and orientation of embedded reinforcement material-can thus be defined with precise spatial resolution and positioning using digitally controlled patterning techniques.

In preferred embodiments, the dielectric material comprises a photo-curable polymer, such as an acrylate-based resin, which can be selectively cured using light-based digital, maskless processes. In such cases, digital light processing DLP and direct laser writing are particularly advantageous, as they enable precise layer-wise patterning of the photopolymer to define complex internal structures-such as chip cavities, interconnect channels, and, in particular, reinforcement channels-without the need for physical masks or tooling. In other or further embodiments, where the dielectric material may be deposited via a flowable medium, inkjet printing and micro-extrusion-based deposition may be used to define the relevant geometries. These and similar digitally controlled processes allow for rapid and flexible adjustment of the reinforcement layout to accommodate specific chip geometries or stress conditions. The ability to digitally tailor the reinforcement structure provides a unique means of precisely modulating residual stress distributions within the chip package-an outcome that is difficult or impossible to achieve using conventional molding or bulk-insertion techniques.

In other or further embodiments, the reinforcement material may be selected to exhibit temperature-dependent mechanical behavior, such that the stress-modulating effect varies under operational or processing temperature conditions. For example, the reinforcement material may comprise a liquid crystal elastomer or another thermally responsive polymer, enabling tunable reinforcement characteristics that adapt to changes in thermal load. Alternatively, the reinforcement material may be configured to provide additional functionality beyond mechanical reinforcement. For instance, the reinforcement structure may be formed from a material exhibiting electromagnetic shielding properties, thereby protecting the embedded components from external interference. In another example, the reinforcement material may possess high thermal conductivity, aiding in the dissipation of heat from the chip die. Additionally, the reinforcement material may be mechanically anisotropic, such that its stiffness or expansion properties differ by orientation, which can be exploited to directionally control internal stress distributions in a manner aligned with the structural layout of the package. These advanced material configurations may be selectively applied depending on the specific mechanical, thermal, or electromagnetic requirements of the chip package design.

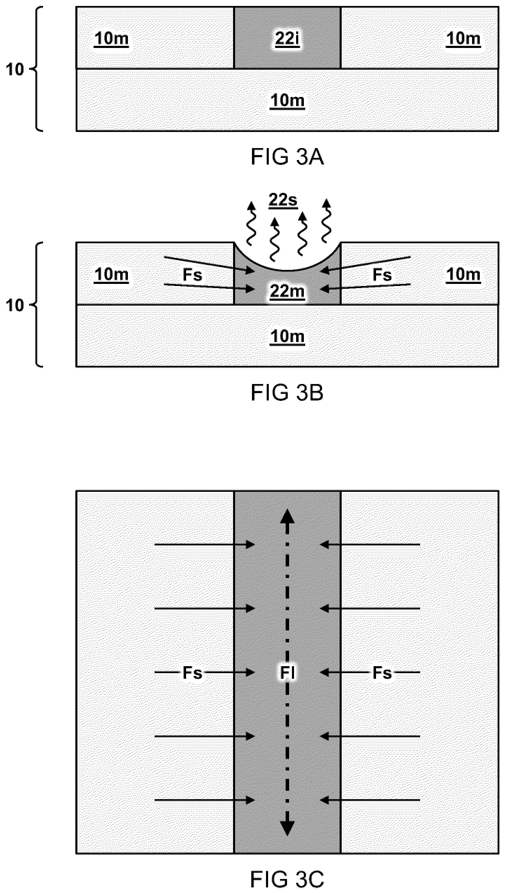

FIGs 3A-3C schematically illustrate a representative mechanism by which groove-filled reinforcement features may modulate residual stress and deformation during the additive manufacturing of a chip package 100. In the example of FIG 3A, a groove is defined in a partially cured or green-state layer of dielectric material 10m and is filled with a flowable reinforcement ink 22i. For example, the reinforcement ink 22i may comprise a suspension of particulate matter-such as metallic, ceramic, or composite particles-within a solvent-based carrier medium.

Upon curing, as shown in FIG 3B, the solvent 22s may evaporate and the ink may solidify to form a conductive and/or reinforcement material 22m within the groove. During this process, the ink undergoes volumetric shrinkage that generates inwardly directed transverse stress components, schematically denoted by Fs, acting on the surrounding dielectric matrix. Simultaneously, the solidified reinforcement material 22m exhibits increased longitudinal stiffness, which resists compression along the groove's length direction, denoted by Fl. The dielectric material surrounding the groove, being in a compliant or semi-cured state during this stage, undergoes localized deformation in response to these competing stress components.

FIG 3C shows a corresponding top view of the reinforcement line after curing. The combined effect of transverse shrinkage-induced prestressing and longitudinal mechanical constraint introduces anisotropic reinforcement into the dielectric structure. Specifically, deformation and warpage are more effectively constrained along the length of the reinforcement groove, while shrinkage in the transverse direction is less restricted. This directional modulation of residual stress can be harnessed to shape the mechanical behavior of the package during cooling and post-curing stages.

By tailoring the geometry, placement, and material properties of the reinforcement features-such as their alignment with stress-prone regions or high-aspect ratio directions of the embedded chip die-residual stress distributions can be selectively redistributed. In preferred embodiments, the reinforcement structure is defined digitally within the manufacturing layout, enabling high-resolution control without requiring additional tooling or process steps. Where the same conductive paste is used for both electrical interconnects and reinforcement material, shared deposition processes (e.g., blade coating) may be employed, provided electrical isolation is ensured through appropriate spatial or dielectric separation. This approach allows reinforcement and electrical functionality to be co-integrated efficiently within the same layer stack.

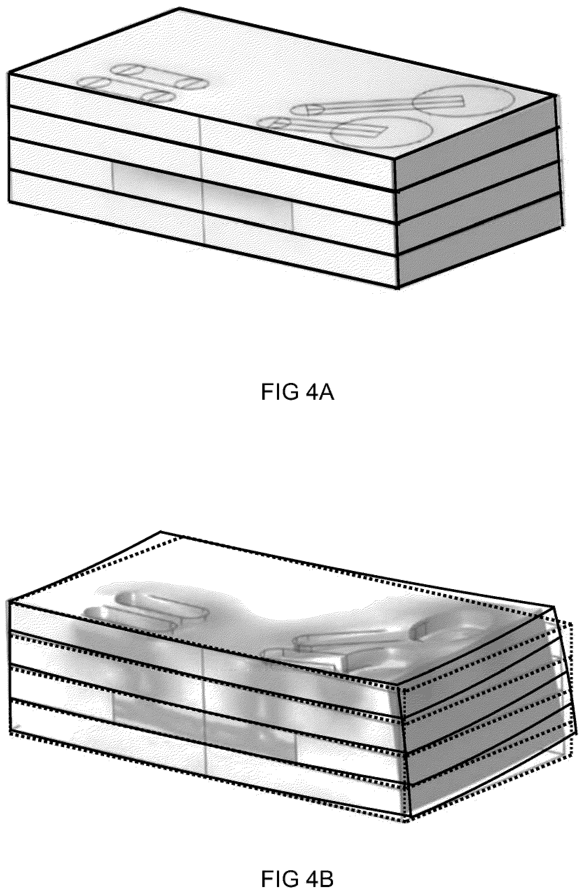

FIGs 4A and 4B illustrate simulated Von Mises stress distributions in a 3D printed chip package 100 after curing and cooling to room temperature (T = 23 °C), in the absence of any embedded reinforcement structures. The figures show a cutaway isometric view of the package structure, with deformations visually exaggerated (by a factor of 2) to enhance clarity. These figures serve to illustrate the stress-related problem addressed by the present invention.

FIG 4A shows a reference case in which the ink or filler material used during fabrication exhibits no cure-induced shrinkage (cure shrinkage 0%). In this case, the stress distribution within the dielectric structure is minimal, and the overall warpage of the package is negligible. FIG 4B shows a comparative case in which the ink material exhibits substantial volumetric shrinkage during curing (cure shrinkage 70%). This results in a significantly altered stress profile, with elevated residual stresses localized near embedded components and interface regions. These stresses arise from cure-induced shrinkage of the ink and thermal contraction during cooling, and may result in mechanical warpage or internal delamination, particularly in packages with thermomechanical mismatches between constituent materials.

These figures illustrate the mechanical reliability challenges that may arise during additive manufacturing of chip packages in the absence of dedicated reinforcement features. Aspects of the present disclosure may alleviate this problem by introducing embedded reinforcement structures configured to modulate and redistribute such residual stresses during the curing process.

FIGs 5A-5C illustrate the influence of different reinforcement groove patterns on the warpage behavior of 3D printed photopolymer specimens, both through simulation (left) and corresponding experimental observations (right). Each figure shows a rectangular photopolymer specimen (20 mm × 20 mm × 0.2 mm) comprising four 50 µm-thick layers of a photo-curable acrylate resin, in which silver-based ink has been deposited into groove patterns and thermally cured. The simulations model only half of the structure due to the use of symmetric boundary conditions.

FIG 5A shows a specimen incorporating a unidirectional groove pattern aligned perpendicular to the direction of observed deformation. The simulation (left) predicts a dominant upward warpage along the free edge. The experimental photograph (right) confirms this behavior, showing curvature concentrated along the transverse axis. The final out-of-plane displacement of a reference edge point after curing and cooling is approximately 0.77 mm (0.91 mm before cooling).

FIG 5B shows a specimen with a grid of orthogonal grooves. The simulation (left) predicts reduced warpage relative to the unidirectional case. The experimental result (right) confirms a more uniform deformation profile. The final z-displacement at the reference edge point is approximately 0.60 mm (0.75 mm before cooling).

FIG 5C shows a specimen incorporating a more dense grid of orthogonal grooves. The simulation (left) predicts a symmetric deformation profile with greater curvature than the other patterns, concentrated toward the center of the structure. The experimental image (right) shows a matching overall warpage pattern. The final z-displacement of the reference point is approximately 1.49 mm (1.76 mm before cooling), indicating increased vertical deformation due to the increased shrinkage constraints introduced by the grid.

These figures demonstrate that the geometry of reinforcement groove patterns may significantly influence the deformation and residual stress profile of additively manufactured polymer structures. The results support the design principle underlying the present invention, whereby directional or patterned reinforcement features may be strategically applied to modulate warpage and control stress distributions during the additive manufacturing process.

The working principles and effects of embedded reinforcement structures in additively manufactured chip packages, e.g. as illustrated in in the preceding figures, may be advantageously applied not only during fabrication but also in the design phase of the chip package. The inventors find that the stress-modulating behavior of groove-filled reinforcement features may be predicted and optimized in advance by simulation. By leveraging these insights in a digital design workflow, it becomes possible to assess the internal mechanical response of a package before manufacturing, and to iteratively adjust the layout and placement of reinforcement features to achieve a targeted reduction in residual stress or deformation. In this context, the reinforcement structure is not only a fabrication-level measure but also a design-driven means of enhancing mechanical performance, allowing structural reliability to be co-optimized alongside functional integration.

Accordingly, aspects of the present disclosure may be further embodied as methods for designing a chip package in which a reinforcement structure is embedded based on simulation or numerical modeling. In some embodiments, an initial digital design is provided, the design comprising a plurality of layers of a dielectric material forming a multilayer packaging structure. The plurality of layers may include one or more electrically functioning components, such as a chip die having a set of electrical contacts, and a set of electrical interconnect structures formed within respective void regions as described herein.

In other or further embodiments, the mechanical behavior of the chip package is evaluated by simulation, for example by numerical modeling of the stress and/or deformation distribution resulting from curing of the dielectric material and cooling to ambient temperature. Preferably, the simulation takes into account one or more thermomechanical properties of the materials involved, such as the coefficient of thermal expansion, cure-induced shrinkage, and elastic modulus of the dielectric material and any other relevant components of the design. In particular, the simulation may include the influence of embedded materials such as conductive tracks or preliminary reinforcement structures, if present.

Based on the simulated output, the stress and/or deformation distribution within the package may be compared with a predefined threshold value, e.g. representing a mechanical tolerance limit. This threshold may correspond to, for example, a maximum allowable in-plane displacement, out-of-plane warpage, or local stress magnitude in critical regions of the structure, such as near the edges or corners of the chip die. If the calculated deformation or stress exceeds this threshold, the initial design may be modified to incorporate a reinforcement structure within one or more layers of the dielectric material.

In some embodiments, the reinforcement structure comprises a plurality of elongated reinforcement lines formed from a reinforcement material that is materially distinct from the dielectric material. The reinforcement lines may be defined in a predetermined pattern that is oriented based on the principal direction of deformation or warpage as determined from the simulation. For example, the pattern may include a set of lines oriented substantially parallel to the in-plane length direction of the chip die, a grid of orthogonal lines extending along the length and width directions, or diagonal lines extending across one or more corners of the chip die. Preferably, the reinforcement structure at least partially overlaps, in projection, with the in-plane footprint of the chip die, and more preferably extends beyond one or more edges of the chip die to promote mechanical anchoring into the surrounding dielectric body.

The reinforcement material may be electrically non-conductive or, alternatively, electrically conductive while remaining electrically isolated from any electrical functionality of the chip package. Preferably, the reinforcement structure is functionally independent from any electrical function of the package. For example, electrical isolation may be ensured by spatial separation from the set of electrical tracks or by interposing one or more intermediate dielectric layers.

The process of simulation, evaluation, and modification may be repeated iteratively until the predicted stress and/or deformation falls below the threshold level. Upon reaching a satisfactory mechanical design, a digital design file is generated, the file comprising geometric definitions of the dielectric structure, the electrical interconnect structures, and the embedded reinforcement pattern. In some embodiments, the digital design file is directly compatible with an additive manufacturing process as described herein, for example a digital, maskless process in which the respective void regions for electrical and mechanical features are defined by digitally controlled patterning.

Preferably, the design file is suitable for generating a physical chip package in which the reinforcement structure is realized by filling corresponding reinforcement channels with a reinforcement material as described elsewhere herein. In this way, a closed-loop design process may be established, wherein the mechanical behavior of the package is modeled in advance and used to inform the placement and configuration of internal reinforcement features, thereby improving the mechanical integrity and dimensional stability of the final structure.

For the purpose of clarity and a concise description, features are described herein as part of the same or separate embodiments, however, it will be appreciated that the scope of the invention may include embodiments having combinations of all or some of the features described. For example, while embodiments were shown for reinforcement structures formed by deposition of ink into grooves within dielectric layers, also alternative ways may be envisaged by those skilled in the art having the benefit of the present disclosure for achieving a similar function and result. E.g. the conductive and/or reinforcement material may be deposited using area-wide or localized techniques, and reinforcement features may be combined or split up into one or more alternative components arranged in the same or different layers. The various elements of the embodiments as discussed and shown offer certain advantages, such as enhanced mechanical integrity, reduced warpage, and improved reliability of additively manufactured chip packages. Of course, it is to be appreciated that any one of the above embodiments or processes may be combined with one or more other embodiments or processes to provide even further improvements in finding and matching designs and advantages. It is appreciated that this disclosure offers particular advantages to chip packaging applications employing additive manufacturing of high-aspect ratio or embedded die structures, and in general can be applied for any application wherein control of residual stress, structural reinforcement, or stress-tolerant multilayer integration is desired.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise.

## Claims

1. A method of manufacturing a chip package (100), the method comprising:
forming a plurality of layers (10) of a dielectric material (10m) using an additive manufacturing process to build up, layer-by-layer, a packaging structure;
wherein one or more of the plurality of layers (10) are structured layers (10s) which are structured by the additive manufacturing process to define respective void regions (11,12,13) within the structured layers (10s);
wherein the respective void regions (11,12,13) include a chip cavity (13) which encapsulates a chip die (23) within the chip package (100), wherein the chip die (23) has a set of electrical contacts (23c);
wherein the respective void regions (11,12,13) further include a set of interconnect channels (11) which are filled by a conductive material (21m) to form a set of electrical tracks (21) embedded in the dielectric material, wherein the set of electrical tracks (21) is electrically connected with the set of electrical contacts (23c) of the chip die (23);
wherein the respective void regions (11,12,13) include a set of reinforcement channels (12) which are filled by a reinforcement material (22m) to form a reinforcement structure (22) embedded in the dielectric material (10m);
wherein the reinforcement material (22m) is materially distinct from the dielectric material (10m) forming the plurality of layers (10);
wherein the reinforcement structure (22) is arranged for structurally reinforcing the dielectric material (10m) of chip package (100), in particular alleviating deformation of the chip package (100) during curing, and functionally independent from any electrical function of the chip package (100).

2. The method according to the preceding claim, wherein the set of reinforcement channels (12) comprise a structured set of open cavities including one or more elongated grooves extending in-plane along the surface of the layer to define a set of reinforcement lines.

3. The method according to the preceding claim, wherein the chip die (23) has an in-plane length that is larger than its in-plane width,
wherein at least some or all of the one or more elongated grooves extends in-plane along the in-plane length direction of the chip die (23) to define respective reinforcement lines that are oriented substantially parallel to said in-plane length direction; and
wherein said reinforcement lines are arranged in a layer that is parallel to the chip die (23) and overlap, in projection onto the same in-plane area, with at least part of the chip die (23), preferably extending at least along the full length of the chip die (23), most preferably extending beyond opposing boundaries of the chip die (23) along the in-plane length.

4. The method according to any of the preceding claims, wherein the set of reinforcement channels (12) comprise a grid pattern of intersecting elongated grooves, wherein the grid pattern comprises a first subset of reinforcement lines extending along the in-plane length direction and a second subset of reinforcement lines extending along the in-plane width direction of the chip die (23)

5. The method according to any of the preceding claim, wherein the set of reinforcement channels (12) comprise one or more elongated grooves oriented diagonally relative to the in-plane axes of the chip die (23), wherein at least some of the elongated grooves extend in-plane across at least one corner of the chip die (23), more preferably extend along a direction substantially aligned with a diagonal axis of the chip die (23), and most preferably form a cross whose legs diagonally extend across opposite corners of the chip die (23); wherein the diagonal reinforcement lines are arranged to overlap, in projection onto the same in-plane area, with at least the corner regions of the chip die (23), and most preferably extend beyond the corners of the chip die (23) into the surrounding dielectric material.

6. The method according to any of the preceding claims, wherein at least part of the reinforcement structure (22) is formed of a conductive reinforcement material (22m), wherein said part is electrically disconnected from any of the electrical contacts (23c) of the chip die (23) and any conductive material (21m) forming the set of electrical tracks (21).

7. The method according to any of the preceding claims, wherein at least one layer (5,7) of the plurality of layers (10) defines respective void regions (11,12,13) which include both parts of the set of interconnect channels (11) and parts of the set of reinforcement channels (12), wherein in the at least one layer (5,7) the parts of the set of reinforcement channels (12) are filled by the same conductive material (21m) as the parts of the set of interconnect channels (11).

8. The method according to any of the preceding claims, wherein all reinforcement material (22m) forming the reinforcement structure (22) is the same as the conductive material (21m) forming the set of electrical tracks (21), wherein the reinforcement structure (22) is electrically isolated from the set of electrical tracks (21).

9. The method according to any of the preceding claims, wherein deposition of the conductive material (21m) and/or the reinforcement material (22m) is performed using a bulk or area-wide deposition technique, wherein all void regions within the same layer are filled with a same material in a single step.

10. The method according to any of the preceding claims, wherein the chip die (23) is pick-and-placed into the chip cavity (13) during manufacturing, such that the chip die (23) is positioned and embedded within the chip package (100) prior to formation of one or more layers of the dielectric material (10) above the chip die (23); wherein the chip die (23) is fully embedded within the chip package (100), including one or more of the plurality of layers (10) formed above the chip die (23) and one or more of the plurality of layers (10) formed below the chip die (23).

11. The method according to any of the preceding claims, wherein the additive manufacturing process is a digital, maskless process, configured to define each of the respective void regions (11,12,13) by digitally controlled patterning.

12. The method according to any of the preceding claims, wherein the reinforcement material (22m) has a lower coefficient of thermal expansion than the dielectric material (10m) and/or a higher elastic modulus than the dielectric material (10m).

13. A method of designing a chip package (100), the method comprising:
providing an initial design of a chip package comprising a plurality of layers of a dielectric material (10m), the layers including one or more electrical functioning components comprising a chip die (23) having a set of electrical contacts (23c), and a set of electrical interconnect structures;
calculating, by simulation or numerical modeling, a stress and/or deformation distribution within the chip package resulting from curing of the dielectric material (10m) and cooling to ambient temperature;
comparing the calculated stress and/or deformation with a predefined threshold tolerance for mechanical integrity of the package;
if the threshold is exceeded, modifying the design by embedding a reinforcement structure (22) into one or more layers of the dielectric material (10m), the reinforcement structure (22) comprising a plurality of elongate reinforcement lines formed from a reinforcement material (22m) that is materially distinct from the dielectric material (10m), the reinforcement structure being arranged in a predefined pattern that is:
oriented in a direction selected based on the principal direction of deformation or warpage,
overlapping with and/or extending beyond the in-plane projection of the chip die (23), and
functionally independent from any electrical function of the chip package;
repeating the steps of calculating, comparing, and modifying until the calculated stress and/or deformation falls within the predefined threshold tolerance; and
generating a digital design file representing the finalized chip package structure, the file comprising geometric definitions of the dielectric layers, the electrical interconnect structures, and the embedded reinforcement pattern, suitable for use in an additive manufacturing process.

14. The method of designing a chip package (100) according to claim 13, wherein the digital design file is used in the additive manufacturing process of the method according to any of claims 1 - 12.

15. A chip package (100), comprising:
a packaging structure built up from a plurality of layers (10) of a dielectric material (10m), the layers forming a multilayer body;
wherein one or more of the plurality of layers (10) are structured layers (10s) comprising respective void regions (11,12,13) defined within the dielectric material (10m);
wherein the void regions include a chip cavity (13) encapsulating a chip die (23) within the packaging structure, the chip die (23) comprising a set of electrical contacts (23c);
wherein the void regions include a set of interconnect channels (11) filled with a conductive material (21m) forming a set of electrical tracks (21) embedded in the dielectric material (10m), the set of electrical tracks (21) being electrically connected with the set of electrical contacts (23c) of the chip die (23);
wherein the void regions include a set of reinforcement channels (12) filled with a reinforcement material (22m) forming a reinforcement structure (22) embedded in the dielectric material (10m);
wherein the reinforcement material (22m) is materially distinct from the dielectric material (10m); and
wherein the reinforcement structure (22) is configured to structurally reinforce the dielectric material (10m) and is functionally independent from any electrical function of the chip package (100).
